## Europäisches Patentamt

(19) **European Patent Office**

**Office européen des brevets**

(11) Veröffentlichungsnummer: **0 052 255**
**B1**

(12) **EUROPÄISCHE PATENTSCHRIFT**

(45) Veröffentlichungstag der Patentschrift:
**12.03.86**

(21) Anmeldenummer: **81108719.6**

(22) Anmeldetag: **22.10.81**

(51) Int. Cl.⁴: **G 01 R  21/00,** G 05 B  9/03

(54) Elektronischer Drehstrom-Elektrizitätszähler.

(30) Priorität: **17.11.80  DE 3043359**

(43) Veröffentlichungstag der Anmeldung:
**26.05.82 Patentblatt 82/21**

(45) Bekanntmachung des Hinweises auf die Patenterteilung:
**12.03.86 Patentblatt 86/11**

(84) Benannte Vertragsstaaten:
**AT CH DE FR GB IT LI**

(56) Entgegenhaltungen:
**DE - A - 2 747 385**
**GB - A - 1 167 903**

**SIEMENS ZEITSCHRIFT, Band 48, Nr. 11, 1974, R. HANS**
**"Neuartige Überwachungs- und Regeleinrichtungen für**
**begleitbeheizte Anlagen", Seiten 846-852**
**RAKETENTECHNIK UND RAUMFAHRTFORSCHUNG,**
**Band 3, 1961, E. DOMBROWSKI "Möglichkeiten zur**
**Erhöhung der Zuverlässigkeit elektronischer Geräte in**
**Flugkörpern", Seiten 101-105**
**Starkstromtechnik, Taschenbuch für Elektrotechniker**
**von Dr.Ing. R. Genthe, Band 1, 1955, Seite 111**

(73) Patentinhaber: **Siemens Aktiengesellschaft, Berlin und**
**München Wittelsbacherplatz 2, D-8000 München 2 (DE)**

(72) Erfinder: **Steinmüller, Günter, Laufamholzstrasse 65,**
**D-8500 Nürnberg (DE)**
Erfinder: **Vieweg, Gunther, Kesslerplatz 13a,**
**D-8500 Nürnberg (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

ACTORUM AG

## Beschreibung

Die Erfindung betrifft einen elektronischen Drehstrom-Elektrizitätszähler, bei dem für jede Phase ein Multiplizierglied vorgesehen ist, dem eingangsseitig die der Phase zugehörigen strom- und spannungsproportionalen Signale zugeführt sind und dessen leistungsproportionales Ausgangssignal zusammen mit den Ausgangssignalen der anderen Multiplizierglieder zu einem Summensignal addiert wird, das in einem Quantisierer in einen Impulszug mit leistungsproportionaler Frequenz umgesetzt wird, der in einer Zähleinrichtung für die zu erfassende Energie zeitlich integriert und angezeigt wird.

Ein derartiger elektronischer Drehstrom-Elektrizitätszähler ist aus der Zeitschrift «Technisches Messen atm 1978, Heft 11, Seiten 407 bis 411» bekannt. Solche Drehstrom-Elektrizitätszähler zeichnen sich durch eine ausserordentlich hohe Messgenauigkeit aus und werden daher bevorzugt an Übergabestellen zwischen einzelnen EVUs oder an Übergabestellen zwischen einem EVU und Grossabnehmern eingesetzt. Diese elektronischen Drehstrom-Elektrizitätszähler weisen jedoch gegenüber konventionellen Drehstrom-Elektrizitätszählern mit Ferraris-Messwerk eine nicht unbeachtlich höhere Ausfallwahrscheinlichkeit auf. Dies ist bedingt durch die Vielzahl der eingesetzten elektronischen Bauelemente. Der überwiegende Teil solcher Bauelementausfälle verursacht einen Fehler des Drehstrom-Elektrizitätszählers, der je nach Anzahl der ausfallenden Multiplizierglieder 33%, 66% oder 100% beträgt. Wegen dieser höheren Ausfallwahrscheinlichkeit elektronischer Drehstrom-Elektrizitätszähler war es bislang erforderlich, zwei Drehstrom-Elektrizitätszähler hintereinander zu schalten und beide Zählerstände von Zeit zu Zeit zu vergleichen. Dies ist jedoch aufwendig und mit erheblichen Kosten verbunden.

Aus dem Buch «Starkstromtechnik, Taschenbuch für Elektrotechniker» von Dr. R. Genthe, Bd. 1, 1955, S. 111, Abb. 39b und 39c, ist eine sogenannte Einwattmeterschaltung bekannt, bei der bei symmetrisch belasteten Drehstromnetzen der Gesamtverbrauch aus dem Verbrauch einer Phase ermittelt wird.

Der Erfindung liegt die Aufgabe zugrunde, einen elektronischen Drehstrom-Elektrizitätszähler nach dem Oberbegriff anzugeben, der bezüglich seiner Funktion selbstüberwachend ausgeführt ist.

Diese Aufgabe wird erfindungsgemäss dadurch gelöst, dass für eine der drei Phasen eine zusätzliche Leistungserfassungseinrichtung, zumindest bestehend aus einem Multiplizierglied und einem Prüfquantisierer vorgesehen ist, die ausgangsseitig einen Impulszug mit leistungsproportionaler Frequenz liefert und dass eine Vergleichseinrichtung für die beiden vom Quantisierer und der Leistungserfassungseinrichtung gelieferten Impulszüge vorgesehen ist, die einen Signalwechsel einer Anzeigeeinheit auslöst, wenn das Verhältnis der Frequenzen der beiden Impulszüge die Grenzen eines bestimmten Toleranzbandes überschreitet, wobei diese Grenzen so gewählt sind, dass der Ausfall eines wesentlichen Bauelementes zur Überschreitung einer Grenze führt und dass für die zusätzliche Leistungserfassungseinrichtung vorhandene Funktionselemente des Drehstrom-Elektrizitätszählers mitbenutzt werden.

Dies beruht auf der Beobachtung, dass ein elektronischer Drehstrom-Elektrizitätszähler aufgrund seines Funktionsprinzips entweder sehr genau arbeitet oder – bei Ausfall eines wesentlichen Bauelementes – sofort einen relativ hohen Fehler aufweist, der beispielsweise im Falle eines Schadens an einem Multiplizierglied 33% beträgt. Aus diesem Grund ist die Festlegung der Grenzen des Toleranzbandes relativ unkritisch. Sie können beispielsweise auf einen Fehler von 15% ausgelegt sein. Wegen der relativ grossen Freiheit in der Wahl der Grenzen des Toleranzbandes kann die Vergleichseinrichtung, die einen Vergleich der beiden Impulszüge bezüglich ihrer Frequenz ausführt, relativ einfach aufgebaut sein. Ein solcher elektronischer Drehstrom-Elektrizitätszähler, der selbstüberwachend ausgestaltet ist, kann nicht nur in Verbindung mit einem symmetrisch belasteten Drehstromnetz mit Vorteil eingesetzt werden, sondern auch bei unsymmetrisch belastetem Drehstromnetz, solange die Unsymmetrie keine extremen Werte aufweist. Wegen der relativen Breite des Toleranzbandes sind kleinere Lastunsymmetrien komplikationslos möglich. Bei einer Breite des Toleranzbandes von $\pm 15\%$ und Zuordnung der zusätzlichen Leistungserfassungseinrichtung zur Phase R kann die Unsymmetrie der Last für die Phase R zwischen den Grenzen $+25,7\%$ und $-17,2\%$, für die Phasen S und T sogar zwischen $\pm 42,9\%$ schwanken, ehe sie als Fehler erkannt wird. Ein solcher selbstüberwachender elektronischer Drehstrom-Elektrizitätszähler ist erheblich billiger als zwei hintereinandergeschaltete Drehstrom-Elektrizitätszähler. Der Kostenaufwand wird insbesondere dadurch gering gehalten, dass für die zusätzliche Leistungserfassungseinrichtung vorhandene Funktionselemente des Drehstrom-Elektrizitätszählers mitbenutzt werden. Damit wird die Zuverlässigkeit der Überwachungseinrichtung sogar noch erhöht. Durch Fernübertragung eines Signalwechsels der Anzeigeeinheit kann ein Fehler des elektronischen Drehstrom-Elektrizitätszählers beispielsweise in einer Schaltwarte erkannt werden, so dass geeignete Massnahmen ergriffen werden können.

Der zusätzlichen Leistungserfassungseinrichtung können die eingangsseitigen Signale oder interne Signale eines einer Phase zugeordneten Multipliziergliedes zugeführt sein. Im erstgenannten Fall werden somit für die zusätzliche Leistungserfassungseinrichtung die netzseitigen Strom- und Spannungswandler zur Erzeugung der strom- und spannungsproportionalen Signale mitbenutzt.

Eine alternative vorteilhafte Ausführungsform besteht darin, dass zumindest eines der den drei Phasen zugeordneten Multiplizierglieder ausgangsseitig ein Spannungssignal liefert und dass zur Bildung der zusätzlichen Leistungserfassungseinrichtung das ausgangsseitige Spannungssignal dieses Multipliziergliedes zusätzlich dem Prüfquantisierer der zusätzlichen Leistungserfassungseinrichtung zugeführt ist. Die zusätzliche Leistungserfassungseinrichtung erfordert wegen dieser Doppelnutzung eines der Multiplizierglieder lediglich den Prüfquantisierer. Der Prüfquantisierer unterscheidet sich im Aufbau nicht von bekannten Quantisierern.

Bei einem Drehstrom-Elektrizitätszähler, bei dem die den einzelnen Phasen zugeordneten Multiplizierglieder als jeweils einen Impulsdauer-Impulspausen-Modulator und einen von diesem gesteuerten Schalter aufweisenden Time-Division-Multiplizierer ausgeführt sind, kann auch als Multiplizierglied der zusätzlichen Leistungserfassungseinrichtung ein Time-Division-Multiplizierer dienen. Time-Division-Multiplizierer liefern ausgangsseitig eine Folge von Impulsen, deren zeitlicher Mittelwert proportional zum Produkt der Eingangsgrössen ist.

Bei einem Drehstrom-Elektrizitätszähler, bei dem ein nach dem Kondensator-Umladeverfahren oder dem Ladungskompensationsverfahren arbeitender Quantisierer zur Verarbeitung des Summensignals dient, kann auch der Prüfquantisierer als nach dem Kondensator-Umladeverfahren oder dem Ladungskompensationsverfahren arbeitend erstellt sein.

Time-Division-Multiplizierer und Prüfquantisierer sind ausser in der eingangs genannten Literaturstelle auch in der DE-OS 2 747 385 nach Aufbau und Wirkung detailliert beschrieben.

Eine vorteilhafte Ausführungsform besteht darin, dass der Schalter des Time-Division-Multiplizierers der zusätzlichen Leistungserfassungseinrichtung von dem Impulsdauer-Impulspausen-Modulator des derjenigen Phase zugehörigen Time-Division-Multiplizierers angesteuert wird, von der auch das zweite zu multiplizierende Signal abgeleitet ist. Damit ist für den Time-Division-Multiplizierer der zusätzlichen Leistungserfassungseinrichtung kein eigener Impulsdauer-Impulspausen-Modulator erforderlich.

Eine bevorzugte Ausführungsform besteht darin, dass die Ansteuerung des Schalters über ein Exclusiv-ODER-Gatter erfolgt, dessen zweiter Eingang mit dem Ausgang des Prüfquantisierers verbunden ist und dass das der entsprechenden Phase zugehörige stromproportionale Signal als Spannungssignal einmal invertiert über einen ersten Widerstand und einmal nicht invertiert über einen zweiten Widerstand und den Schalter dem Eingang des Prüfquantisierers zugeführt ist, wobei der erste Widerstand den doppelten Widerstandswert des zweiten aufweist. Dies ist aus der DE-OS 2 747 385 bei einem Time-Division-Multiplizierer an sich bekannt. Bei einem Drehstrom-Elektrizitätszähler für beide Energieflussrichtungen mit einem Energierichtungsdiskriminator besteht eine bevorzugte Ausführungsform darin, dass das bistabile Ausgangssignal des Energierichtungsdiskriminators dem einen Eingang eines weiteren Exclusiv-ODER-Gatters zugeführt ist, dass das Ausgangssignal des Prüfquantisierers am zweiten Eingang des weiteren Exclusiv-ODER-Gatters ansteht und dass der Ausgang des weiteren Exclusiv-ODER-Gatters mit dem zweiten Eingang des Exclusiv-ODER-Gatters verbunden ist. Damit ist erreicht, dass auch ein Drehstrom-Elektrizitätszähler für beide Energieflussrichtungen zur Selbstüberwachung bezüglich des Ausfalls wichtiger Bauelemente ertüchtigt ist.

Die Vergleichseinrichtung für die beiden, vom Quantisierer und dem Prüfquantisierer der zusätzlichen Leistungserfassungseinrichtung gelieferten Impulszüge kann einen zurückstellbaren Zähler aufweisen, dessen Zähleingang der eine Impulszug zugeführt ist, wobei die Zahl der eingehenden Impulse für jeweils eine durch Frequenzteilung aus dem anderen Impulszug abgeleitete Zykluszeit erfasst und am Ende der Zykluszeit jeweils vor Rückstellung des Zählers daraufhin überprüft wird, ob sie ausserhalb des bei einer einwandfreien Funktion aller den drei Phasen zugeordneten Funktionsgruppen des Drehstrom-Elektrizitätszählers gegebenen Toleranzbandes liegt. Damit ist eine einfache und kostengünstige Vergleichseinrichtung herstellbar.

Als rückstellbarer Zähler kann ein Binärzähler dienen. Binärzähler sind kostengünstig im Handel verfügbar und gestatten wegen der Unkompliziertheit der an den Ausgängen zur Verfügung gestellten Information eine einfache Weiterverarbeitung des Zählerinhalts.

Zur Bildung der Zykluszeit kann dem Quantisierer ein Frequenzteiler nachgeschaltet sein, dessen Ausgangsimpulse auch die Zähleinrichtung für die zu erfassende elektrische Energie speisen.

Die das Toleranzband bestimmenden Zahlenwerte können durch ein oder gegebenenfalls mehrere durch eine logische Verknüpfungsschaltung verknüpfte Ausgangssignale des Binärzählers dargestellt sein. Damit ist in einfacher Weise das Toleranzband als ein bestimmtes Zahlenintervall darstellbar.

Eine bevorzugte Ausführungsform besteht darin, dass das Ausgangssignal des Binärzählers beziehungsweise der logischen Verknüpfungsschaltung an den D-Eingang eines D-Flip-Flops geführt ist und dass das die Zykluszeit bestimmende Ausgangssignal des Frequenzteilers am Takteingang des D-Flip-Flops und über ein Verzögerungs- und ein Differenzierglied am Rücksetzeingang des Binärzählers ansteht. Damit ist auf unkomplizierte Weise eine kostengünstige Realisierung der Vergleichseinrichtung erreicht. Die Anzeigeeinheit kann vom Ausgangssignal des D-Flip-Flops gesteuert sein. Ein Signalwechsel am Ausgang des D-Flip-Flops und damit der Anzeigeeinheit tritt dann auf, wenn in der vorangehenden Zykluszeit in den Binärzähler eine jenseits der Grenzen des Toleranzbereiches liegende Anzahl von Impulsen eingezählt wurde und diese getriggert durch das impulsförmige Ausgangssignal des Frequenzteilers das diese Grenzüberschreitung signalisierende logische Signal in das D-Flip-Flop übernommen wird.

In einer vorteilhaften Ausführungsform ist das Ausgangssignal des Binärzählers, das um eine Wertigkeit höher ist als das höchstwertige an den D-Eingang des D-Flip-Flops geführte Signal des Binärzählers, an den Rücksetzeingang des D-Flip-Flops geführt. Damit ist bei Überschreitung der oberen Grenze des Toleranzbereichs in jedem Fall eine Strömungsanzeige gesichert.

Die Erfindung wird im folgenden anhand von Ausführungsbeispielen näher erläutert. Dabei zeigt:

Fig. 1 ein Prinzipschaltbild eines elektronischen Drehstrom-Elektrizitätszählers mit Selbstüberwachung,

Fig. 2 ein detailliertes Ausführungsbeispiel eines solchen elektronischen Drehstrom-Elektrizitätszählers,

Fig. 3 die Vergleichseinrichtung im Detail und

Fig. 4 ein Zustandsdiagramm der Ausgänge Q5 bis Q7 des Binärzählers.

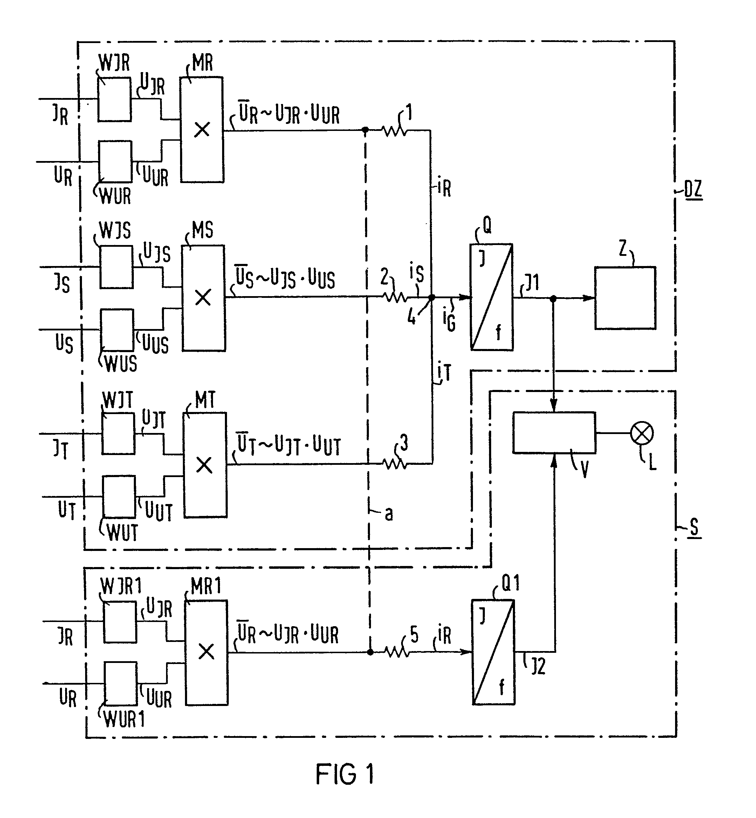

Bei dem in Fig. 1 dargestellten Prinzipschaltbild ist ein beispielsweise aus der eingangs genannten Literaturstelle bekannter elektronischer Drehstrom-Elektrizitätszähler gestrichelt umrandet und mit dem Bezugszeichen DZ belegt. Hierbei ist jeder der drei Phasen R, S, T ein Multiplizierglied MR, MS, MT zugeordnet. Da die die Multiplizierglieder enthaltenden Signalzweige für die drei Phasen R, S und T untereinander baugleich sind, genügt es den der Phase R zugeordneten Signalzweig näher zu erläutern.

Das Multiplizierglied MR erhält eingangsseitig die Signalspannungen $U_{IR}$ und $U_{UR}$, wobei erstere proportional zu dem momentanen Phasenstrom $I_R$ durch den Wandler WIR, letztere proportional zur Phasenspannung $U_R$ durch den Wandler WUR gewonnen ist. Am Ausgang des Multipliziergliedes MR tritt das leistungsproportionale Ausgangssignal $\overline{U}_R$ auf. Die leistungsproportionalen Ausgangssignale $\overline{U}_R$, $\overline{U}_S$ und $\overline{U}_T$ der den drei Phasen R, S und T zugeordneten Multiplizierglieder werden durch die Widerstände 1, 2, 3, die gleiche Widerstandwerte aufweisen, in proportionale Ströme $i_R$, $i_S$, $i_T$ gewandelt, die im Summenpunkt 4 zum Summenstrom $i_G$ aufaddiert sind. Der Summenstrom $i_G$ steht am Eingang des Quantisierers Q an, der ausgangsseitig einen Impulszug I1 erzeugt, dessen Frequenz proportional zu der dem Drehstromsystem entnommenen und durch den Drehstrom-Elektrizitätszähler DZ zu erfassenden Gesamtleistung ist. Der Impulszug I1 ist einer Zähleinrichtung Z für die zu erfassende Energie zugeführt, in der der Impulszug I1 zeitlich integriert und das Ergebnis angezeigt wird. Zur Geschwindigkeitsanpassung an die Zähleinrichtung Z kann es erforderlich sein, dem Quantisierer Q einen Frequenzuntersetzer nachzuschalten. Dies ist aus Gründen der Übersichtlichkeit hier nicht dargestellt.

Als Teil einer Selbstüberwachungseinrichtung S ist nun ein weiterer ein Multiplizierglied MR1 enthaltender Signalzweig aufgebaut, der über die beiden Wandler WIR1 und WUR1 ebenfalls an die Netzphase R angekoppelt ist. Anstelle der Phase R könnte ebensogut die Ankopplung an eine der anderen Phasen erfolgen. Das der Phasenleistung proportionale Ausgangssignal $\overline{U}_R$ des Multipliziergliedes MR1 wird über den Widerstand 5 dem Eingang des Prüfquantisierers Q1 zugeführt, der baugleich mit dem Quantisierer Q ist. Am Ausgang des Prüfquantisierers Q1 steht der Impulszug I2 zur Verfügung, dessen Frequenz proportional zur Phasenleistung der Phase R ist.

Die beiden Impulszüge I1, I2 sind einer Vergleichseinrichtung V zugeführt, die das Verhältnis der Frequenzen der beiden Impulszüge I1 und I2 überwacht. Im Prinzip kann die Vergleichseinrichtung V aus zwei den Impulszügen I1 und I2 zugeordneten Frequenzwandlern, die ausgangsseitig ein frequenzproportionales elektrisches Signal, z.B. ein Gleichspannungssignal, abgeben, aus einem Dividierglied zur Verhältnisbildung der beiden elektrischen Signale sowie aus einem nachgeschalteten Grenzwertmelder mit zwei, die Grenzen des Toleranzbandes festlegenden Grenzwerten, bei deren Überschreitung ein Signal auftritt.

Fällt nun beispielsweise das der Phase R zugeordnete Multiplizierglied MR aus, dann sinkt die Frequenz des Impulszuges I1 auf zwei Drittel ihres vorherigen Wertes ab. Die Frequenz des Impulszuges I2 bleibt dagegen erhalten, da der zugehörige Signalzweig autark ausgeführt ist. Diese gravierende Änderung des Frequenzverhältnisses der beiden Impulszüge I1 und I2 wird in der Vergleichseinrichtung V erkannt und führt zu einem Signalwechsel an der als Glühlampe dargestellten Anzeigeeinheit L. Das Toleranzband für das Verhältnis der Frequenz der Impulszüge I1 und I2 ist hierbei etwa so gewählt, dass die Grenzen des Toleranzbandes bei einer Änderung des Frequenzverhältnisses von ±15% liegen.

Als Multiplizierglieder können beliebige bekannte Multiplizierglieder insbesondere Time-Division-Multiplizierglieder nach Art der aus der eingangs erwähnten Literaturstelle oder der DE-OS 2 747 385 bekannten eingesetzt werden. Aus den gleichen Literaturstellen sind Quantisierer nach dem Kondensator-Umladeverfahren und Quantisierer nach dem Ladungskompensationsverfahren bekannt, die als Quantisierer Q bzw. Prüfquantisierer Q1 eingesetzt werden können.

Anstelle der bislang erörterten zusätzlichen Leistungserfassungseinrichtung, die die Wandler WIR1 und WUR1, das Multiplizierglied MR1, den Widerstand 5 sowie den Quantisierer Q1 umfasst, kann eine einfachere, kostengünstigere Leistungserfassungseinrichtung eingesetzt sein. In diesem Fall entfallen die Wandler WIR1 und WUR1 sowie das Multiplizierglied MR1. Stattdessen ist das dem Prüfungsquantisierer Q1 abgewandte Ende des Widerstandes R1 – wie durch die gestrichelte Linie a veranschaulicht – an den Ausgang des Multipliziergliedes MR oder eines der anderen Multiplizierglieder angeschlossen. Das Multiplizierglied MR sowie die beiden vorgeschalteten Wandler WIR und WUR werden hierbei einer Doppelnutzung zugeführt, nämlich zum einen einer Nutzung im Rahmen des elektronischen Drehstrom-Elektrizitätszählers DZ und zum anderen im Rahmen der zusätzlichen Leistungserfassungseinrichtung. Fällt nunmehr das Multiplizierglied MR aus, erniedrigt sich die Frequenz des Impulszuges I1 um ein Drittel, wohingegen die Frequenz des vom Prüfquantisierer Q1 abgeleiteten Impulszuges I2 auf Null zurückgeht. Die damit einhergehende gravierende Veränderung des Verhältnisses der Frequenzen der beiden Impulszüge I1 und I2 führt zum Überschreiten der Grenzen des Toleranzbandes in der Vergleichseinrichtung V und zu einem eine Störung signalisierenden Wechsel an der Anzeigeeinheit L.

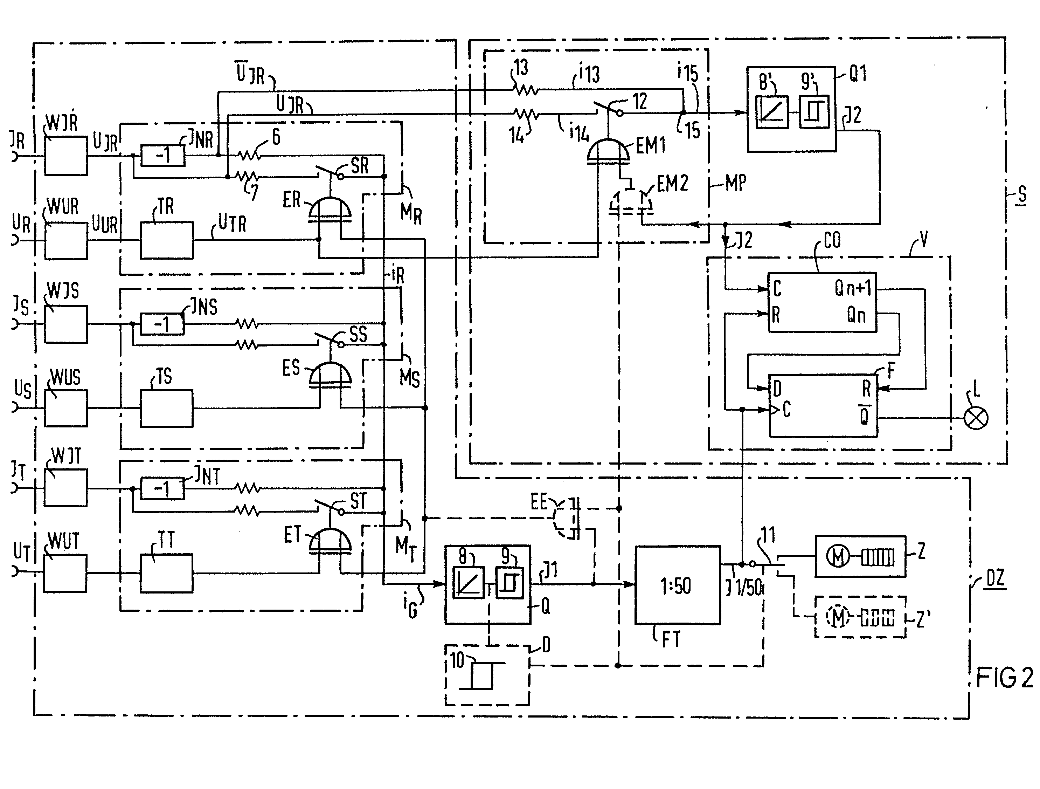

Um die zusätzliche Leistungserfassungseinrichtung kostengünstig zu halten, können auch die eingangsseitigen Signale oder interne Signale eines einer Phase zugeordneten Multipliziergliedes als Eingangssignale der zusätzlichen Leistungserfassungseinrichtung genutzt sein. Im erstgenannten Fall werden damit immerhin eigene eingangsseitige Wandler – wie die Wandler WIR1 und WUR1 des in Fig. 1 dargestellten Ausführungsbeispiels – überflüssig gemacht. Ein Beispiel für die Nutzung interner Signale eines einer Phase zugeordneten Multipliziergliedes für die zusätzliche Leistungserfassungseinrichtung zeigt das in Fig. 2 dargestellte Ausführungsbeispiel.

Hierbei sind die den drei Phasen R, S, T zugeordneten Multiplizierglieder MR, MS und MT des elektronischen Drehstrom-Elektrizitätszählers DZ als Time-Division-Multiplizierer ausgeführt. Der Aufbau und ihre Wirkunsweise ist voll identisch mit dem in Fig. 1 der DE-OS 2 747 385 im Rahmen eines Wechselstromzählers dargestellten Time-Division-Multiplizierer.

Da die den drei Phasen R, S, T zugeordneten Multiplizierglieder MR, MS, MT untereinander baugleich sind, soll nur das der Phase R zugeordnete Multiplizierglied MR näher erläutert werden. Das der Phasenspannung $U_R$ proportionale Ausgangssignal des Wandlers WUR stellt die Eingangsgrösse des Impulsdauer-Impulspausen-Modulators TR dar, der beispielsweise ebenso aufgebaut sein kann, wie der aus der bereits mehrfach erwähnten DE-OS 2 747 385 bekannte. Das Ausgangssignal dieses Impulsdauer-Impulspausen-Modulators TR ist dem einen Eingang des Exclusiv-ODER-Gatters ER zugeführt. Der zweite Eingang dieses Exclusiv-ODER-Gatters ER ist prinzipiell direkt mit dem Ausgang des Quantisierers Q verbunden. Das Ausgangssignal dieses Gatters dient zur Steuerung des Schalters SR, der vorzugsweise als Transistor ausgeführt ist.

Das stromproportionale Ausgangssignal $U_{IR}$ des Wandlers WIR, das das zweite für die Produktbildung erforderliche Signal darstellt, ist einerseits über das Invertierglied INR und den Widerstand 6 und andererseits parallel dazu über den Widerstand 7 und den Schalter SR dem Eingang des Quantisierers Q zugeführt. Durch die Widerstände 6 und 7 wird das Eingangssignal $U_{IR}$ in Ströme gewandelt. Hierbei ist der Widerstandswert des Widerstandes 7 nur halb so gross wie der des Widerstandes 6, so dass der über den Schalter SR geführte Strom doppelt so gross ist wie der im Parallelzweig geführte Strom. Das Ausgangssignal $i_R$ des Multipliziergliedes MR stellt somit positive und negative Stromblöcke dar, deren Dauer durch das Tastverhältnis des Impulsdauer-Impulspausen-Modulators TR bestimmt ist und deren zeitlicher Mittelwert proportional zu dem Produkt aus Phasenspannung $U_R$ und Phasenstrom $I_R$ ist.

Die Ausgangsströme der als Time-Division-Multiplizierer ausgeführten Multiplizierglieder MR, MS, MT sind zum Gesamtstrom $i_G$ zusammengeführt, der den Quantisierer Q speist.

Der in Fig. 2 dargestellte Quantisierer Q arbeitet nach dem Kondensator-Umladeverfahren und weist einen Integrator 8 und eine nachgeschaltete Grenzwertstufe 9 mit einem oberen und einem unteren Grenzwert auf. Der impulsförmige Summenstrom $i_G$ der Multiplizierglieder MR, MS, MT wird im Integrator 8 zeitlich integriert, bis die Ausgangsspannung des Integrators 8 beispielsweise den oberen Grenzwert der Grenzwertstufe 9 erreicht. Damit geht das Ausgangssignal des Quantisierers Q in den anderen seiner beiden möglichen Zustände über. Dieser Signalwechsel am Ausgang des Quantisierers Q bewirkt, dass am Ausgang der Exclusiv-ODER-Gatter ER, ES und ET nunmehr das invertierte Signal der zugehörigen Impulsdauer-Impulspausen-Modulatoren TR, TS und TT zur Steuerung der Schalter Sr, SS und ST erscheint. Hatte bislang der Summenstrom $i_G$ einen positiven Strommittelwert, so wird dieser nunmehr negativ. Damit nimmt nunmehr die Ausgangsspannung des Integrators 8 solange ab, bis der untere Grenzwert der Grenzwertstufe 9 erreicht ist und ein erneuter Signalwechsel am Ausgang des Quantisierers Q erfolgt. Es entsteht somit ein rechteckförmiger Impulszug I1, dessen Frequenz proportional zu der durch den Drehstromzähler DZ erfassten Leistung ist.

Dieser Impulszug I1 wird in einem Frequenzteiler FT im Verhältnis 1:50 untersetzt. Der ausgangsseitige Impulszug I1/50 wird in einer Zähleinrichtung Z zeitlich integriert. Diese Zähleinrichtung Z kann beispielsweise aus einem Schrittmotor M bestehen, der ein Rollenzählwerk A antreibt.

Der elektronische Drehstrom-Zähler DZ kann auch so ausgebildet sein, dass er für beide Energieflussrichtungen einsetzbar, d.h. zur Erfassung sowohl der bezogenen als auch der gelieferten Energie ertüchtigt ist. Ein derartiger Drehstrom-Elektrizitätszähler ist ebenfalls aus der eingangs genannten Literaturstelle bekannt. Bei dem in Fig. 2 dargestellten Ausführungsbeispiel sind die hierfür zusätzlich erforderlichen schaltungstechnischen Massnahmen gestrichelt eingezeichnet. Das Ausgangssignal des Integrators 8 ist hierbei einem Energierichtungsdiskriminator D zugeführt, der im wesentlichen eine Grenzwertstufe 10 mit zwei Grenzwerten enthält, von denen der eine oberhalb des oberen Grenzwertes und der andere unterhalb des unteren Grenzwertes der Grenzwertstufe 9 liegt. Das bivalente Ausgangssignal des Energierichtungsdiskriminators D und der Impulszug I1 des Quantisierers Q sind hierbei den beiden Eingängen eines Exclusiv-ODER-Gatters EE zugeführt, dessen Ausgangssignal an einem der Eingänge der Exclusiv-ODER-Gatter ER, ES und ET ansteht. Darüber hinaus ist zusätzlich ein Umschalter 11 erforderlich, der ebenfalls von dem bivalenten Ausgangssignal des Energierichtungsdiskriminators D gesteuert wird. Durch den Umschalter 11 wird beispielsweise das Ausgangssignal I1/50 des Frequenzteilers FT bei Energiebezug der Zähleinrichtung Z, bei Energielieferung jedoch der weiteren Zähleinrichtung Z' zugeführt. Um den Drehstrom-Elektrizitätszähler selbstüberwachend zu gestalten, ist eine zusätzliche Leistungserfassungseinrichtung, bestehend aus dem Multiplizierglied MP und dem Prüfquantisierer Q1, eine Vergleichseinrichtung V für die beiden, vom Quantisierer Q und dem Prüfquantisierer Q1 gelieferten Impulszüge und eine Anzeigeeinheit L vorgesehen. Diese Funktionselemente sind in Fig. 2 in dem strichpunktiert eingezeichneten Rechteck S enthalten.

Das Multiplizierglied MP ist als Time-Division-Multiplizierer aufgebaut, wobei jedoch – um Bauelemente zu sparen – interne Signale des der Phase R zugeordneten, grundsätzlich baugleichen Multipliziergliedes MR verwendet sind. So weist das Multiplizierglied MP keinen eigenen Impulsdauer-Impulspausen-Modulator auf, sondern benutzt das Ausgangssignal $U_{TR}$ des der Phase R zugeordneten Impulsdauer-Impulspausen-Modulators TR. Darüber hinaus wird für das Multiplizierglied MP die an den Widerständen 6 und 7 anliegende invertierte und nicht invertierte Spannung $\bar{U}_{IR}$ bzw. $U_{IR}$ benutzt. Damit wird für das Multiplizierglied MP neben dem Impulsdauer-Impulspausen-Modulator TR auch das Invertierglied INR des der Phase R zugeordneten als Time-Division-Multiplizierer ausgebildete Multipliziergliedes MR mitbenutzt. Damit braucht das Multiplizierglied MP auch keine eigenen Wandler für die Phasenspannung sowie für den Phasenstrom.

Die an den Widerständen 6 und 7 abgegriffenen Spannungen $\bar{U}_{IR}$ und $U_{IR}$ werden über die Widerstände 13 und 14 in proportionale Ströme i13 und i14 gewandelt. Im Strompfad des Stromes i14 liegt der vorzugsweise als Transistorschalter ausgebildete steuerbare Schalter 12, der durch das Ausgangssignal des Exclusiv-ODER-Gatters EM1 gesteuert ist. Den Eingängen dieses Exclusiv-ODER-Gatters EM1 ist einerseits das Ausgangssignal des Impulsdauer-Impulspausen-Modulators TR andererseits das Ausgangssignal I2 des Prüfquantisierers Q1 zugeführt. Ist der Drehstromzähler DZ zur Erfassung beider Energieflussrichtungen ausgestattet, ist ein weiteres Exclusiv-ODER-Gatter EM2 notwendig, dessen Eingänge mit den Ausgängen des Prüfquantisierers Q1 und des Energierichtungsdiskriminators D verbunden sind und dessen Ausgang an den anderen Eingang des Exclusiv-ODER-Gatters EM1 angeschlossen ist. Der Strom i13 sowie der durch die Betätigung des Schalters 12 getastete Strom i14 sind im Summenpunkt 15 zu einem positive und negative Stromblöcke aufweisenden Summenstrom i15 zusammengefasst, der den Prüfquantisierer Q1 speist.

Der Prüfquantisierer Q1 ist mit dem Quantisierer Q baugleich und arbeitet damit wie dieser nach dem Kondensator-Umladeverfahren. Damit entsteht am Ausgang des Prüfquantisierers Q1 ein Impulszug I2, dessen Frequenz proportional zur Leistung der Phase R ist.

Der vom Prüfquantisierer Q1 stammende Impulszug I2 sowie der aus dem Impulszug I1 durch Frequenzteilung im Frequenzteiler FT abgeleitete Impulszug I1/50 werden der Vergleichseinrichtung V zugeführt. Diese Vergleichseinrichtung, die grundsätzlich einen Frequenzvergleich der beiden ankommenden Impulszüge durchzuführen hat, ist in Fig. 2 besonders elegant und einfach aufgebaut. Sie weist einen zurückstellbaren Zähler O sowie ein bistabiles Flip-Flop F auf, wobei in Abhängigkeit vom Ausgangszustand des Flip-Flops F eine als Anzeigeeinheit L dienende Lampe angesteuert wird. Dem Zähleingang Z des zurückstellbaren Zählers CO ist der Impulszug I2 zugeführt, wohingegen der Rückstelleingang dieses Zählers von dem die Zykluszeit vorgebenden Signalzug I1/50 beaufschlagt ist. Am Ende einer Zykluszeit wird vor Zurückstellung des Zählers CO der Zählerstand durch Abfragen mindestens eines Ausganges Qn des Zählers CO daraufhin überprüft, ob während dieser Zykluszeit nicht zuviel oder zuwenig Impulse des Impulszuges I2 eingegangen sind, was ja auf einen Fehler im Drehstromzähler schliessen liesse. Falls dies der Fall ist, wird am Ausgang des Flip-Flops F ein Signalwechsel erzwungen, der einen eine Störung signalisierenden Signalwechsel der Anzeigeeinheit L zur Folge hat.

Anstelle des Impulszuges I1 kann auch der Impulszug I2 zur Ableitung der Zykluszeit nach Frequenzuntersetzung im Frequenzteiler FT benützt werden. In diesem Fall würde der Zähleingang Z des zurückstellbaren Zählers CO mit dem Impulszug I1 beaufschlagt werden.

Da beide Impulszüge eine leistungsproportionale Frequenz aufweisen – die Frequenz des Impulszuges I1 ist proportional zur Leistung des Drehstromnetzes, die Frequenz des Impulszuges I2 proportional zur Leistung einer Phase (Phase R) – ändern sich Zykluszeit und Frequenz des im Zähler CO zu erfassenden Impulszuges derart gegenläufig, dass trotz einer Grösse des Messbereichs des Drehstrom-Elektrizitätszählers von 1:100 innerhalb einer Zykluszeit immer in guter Näherung die gleiche Anzahl von Impulsen innerhalb einer Zykluszeit in den Zähler CO eingezählt wird. Voraussetzung hierfür ist allerdings, dass entweder das Netz symmetrisch belastet ist oder eine nur kleinere Unsymmetrie zeitlich konstant erhalten bleibt. Bei einer Steigerung der Entnahmeleistung steigen sowohl die Frequenz des Impulszuges I1 als auch des Impulszuges I2. Da aber die Zykluszeit und damit die Zeitspanne, in der im Ausführungsbeispiel der Impulszug I2 in den rückstellbaren Zähler CO eingezählt wird, sich entsprechend dem Anstieg der Frequenz des Impulszuges I2 verkürzt, bleibt die Zahl der in einer Zykluszeit in den Zähler CO eingehenden Impulse in guter Näherung gleich.

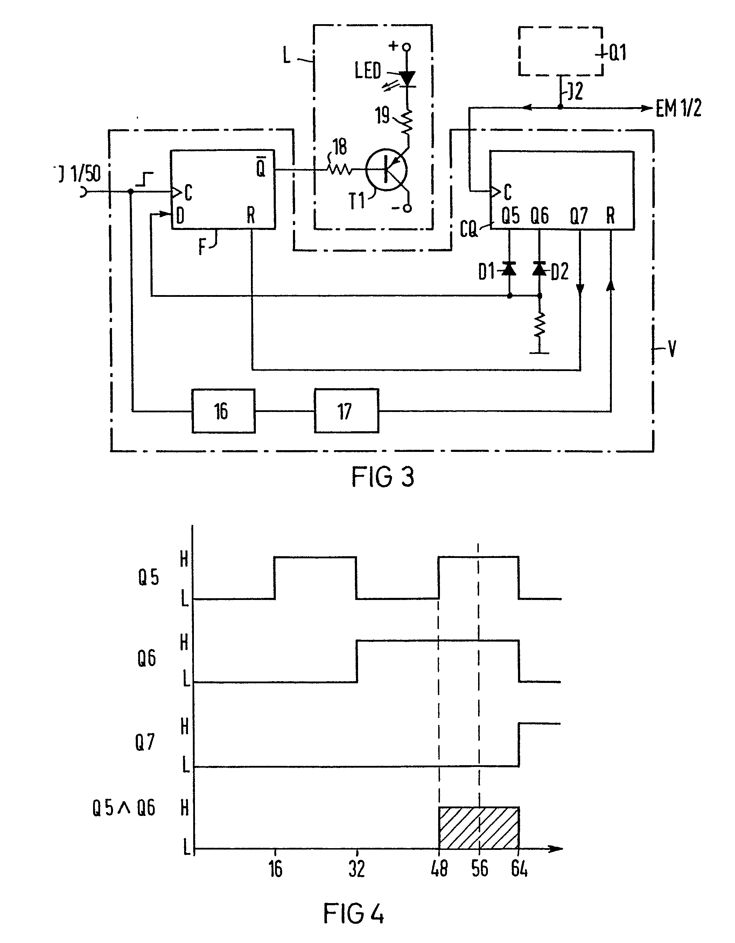

Die Vergleichseinrichtung V ist in Fig. 3 detailliert dargestellt. Hierbei wird in der Folge davon ausgegangen, dass die Frequenz des Impulszuges I2 das 56-fache der Frequenz des am Ausgang des Frequenzteilers FT anstehenden Impulszuges I1/50 ist. Diese Frequenzeinstellung kann durch eine Reihe von Massnahmen erreicht werden, so z.B. durch die entsprechende Dimensionierung der Widerstände 13 und 14, durch die Anpassung der Steilheit des Integrators 8' oder durch entsprechende Wahl der Grenzwerte der Grenzwertstufe 9' des Prüfquantisierers Q1. Die Zykluszeit entspricht der Dauer einer Periode des Impulszuges I1/50 bzw. der Dauer von 50 Perioden des Impulszuges I1. Die Impulse des vom Prüfquantisierer Q1 stammenden Impulszuges I2 sind dem Zähleingang des zurückstellbaren Zählers CO zugeführt. Dieser Zähler ist als Binärzähler mit einem Speichervermögen von sieben Bit ausgebildet. Der Inhalt des Zählers CO ist als Zustand der bivalenten Ausgänge Qn erkennbar, wobei in dem in Fig. 3 dargestellten Ausführungsbeispiel lediglich die Ausgänge Q5 bis Q7 eingezeichnet sind. Die Ausgänge Q5 und Q6 sind über die beiden parallel geschalteten Dioden D1 und D2 an den Vorbereitungseingang D des als D-Flip-Flop ausgebildeten bistabilen Flip-Flops F geführt. Die beiden Dioden D1 und D2 wirken als UND-Gatter. Der Ausgang Q7 des Zählers CO ist an den Rückstelleingang R des Flip-Flops F gelegt. Der Impulszug I1/50 ist einerseits direkt an den Takteingang C des Flip-Flops F, andererseits über ein Verzögerungsglied 16 und ein nachgeschaltetes Differenzierglied 17 an den Rückstelleingang des Zählers CO gelegt. Der Signalzustand am invertierenden Ausgang Q des Flip-Flops F dient zur Steuerung der Anzeigeeinheit L.

Bei dieser Anzeigeeinheit L ist eine Leuchtdiode LED zur Anzeige des Betriebszustandes genutzt. Hierbei ist die Serienschaltung aus Leuchtdiode LED, Strombegrenzungswiderstand 19 und Schaltstrecke des Transistors T1 zwischen die Pole einer Speisungsspannungsquelle gelegt. Die Basis des Transistors T1 ist über den Basiswiderstand 18 mit dem invertierenden Ausgang $\bar{Q}_4$ des Flip-Flops F verbunden.

Zur Erläuterung der Wirkungsweise wird davon ausgegangen, dass mit der ansteigenden Flanke eines Impulses des Impulszuges I1/50 soeben ein am Vorbereitungseingang D anstehendes H-Signal in das D-Flip-Flop übernommen wurde. Am invertierenden Ausgang $\bar{Q}$ steht damit L-Signal an, wodurch der Transistor T1 aufgesteuert ist und die Leuchtdiode LED zur Anzeige eines störungsfreien Betriebszustandes leuchtet. Nach Übernahme des H-Signals am Vorbereitungseingang D wurde der Zähler CO durch ein ebenfalls von der ansteigenden Flanke des Impulses des Impulszuges I1/50 über das Verzögerungsglied 16 und das Differenzierglied 17 abgeleitetes Signal zurückgesetzt. In der nun begonnenen neuen Zykluszeit werden die Impulse des Impulszuges I2 im Zähler CO addiert.

In Fig. 4 ist ein Zustandsdiagramm der Ausgänge Q5, Q6, Q7 sowie der Funktion Q5 ∧ Q6 dargestellt. Sobald der Zähler CO einen Inhalt zwischen 48 und 64 Impulsen aufweist, erscheint aufgrund der durch die beiden Dioden D1 und D2 realisierten UND-Beziehung am Vorbereitungseingang D H-Signal. Endet der eben begonnene Taktzyklus mit dem Auftreten der ansteigenden Flanke des nächsten Impulses des Impulszuges I1/50 während H-Signal am Vorbereitungseingang D ansteht, wird dieses Signal ins D-Flip-Flop übernommen, so dass die Leuchtdiode weiterhin leuchtet. Die Impulszahlen zwischen 48 und 64 stellen somit die Grenzen des Toleranzbandes dar, dessen Mitte gemäss der im voranstehenden beschriebenen Einstellung der Frequenz des Prüfquantisierers bei 56 Impulsen liegt. Diese Grenzen des Toleranzbandes entsprechen damit einer Abweichung von $\pm 14,3\%$. Selbstverständlich können durch entsprechende Auswahl und Verknüpfung von Ausgängen des Zählers CO auch andere Grenzen für schmaleres oder breiteres Toleranzband gewählt werden. Geht nach Rückstellung des Zählers CO zu Beginn der folgenden Zykluszeit während dieser Zykluszeit eine Impulszahl ein, die kleiner als 48 ist, steht am Vorbereitungseingang D aufgrund der UND-Verknüpfung der Ausgänge Q5 und Q6 L-Signal an, das am Ende der Zykluszeit in das D-Flip-Flop übernommen wird, worauf am invertierenden Ausgang $\bar{Q}_4$ H-Signal auftritt, das die Leuchtdiode LED zum Erlöschen bringt. Damit ist ein 14,3% übersteigender Fehler signalisiert, der auf einen Ausfall wesentlicher Komponenten, also beispielsweise eines der Multiplizierglieder MR, MS, MT, des elektronischen Drehstrom-Elektrizitätszählers hinweist. Dieselbe Wirkung tritt auf, wenn zum Ende einer Zykluszeit der Inhalt des Zählers CO den Wert 64 übersteigt und damit der Ausgang Q7 aktiv wird, was zu einem sofortigen Zurücksetzen des D-Flip-Flops F und anschliessendem Erlöschen der Leuchtdiode LED führt. Die Verbindung des Ausganges Q7 des Zählers CO mit dem Rücksetzeingang R des D-Flip-Flops F führt dazu, dass der eine Störung anzeigende Signalwechsel der Anzeigeeinheit L zuverlässig auch immer dann auftritt, wenn eine Störung zu einer Frequenzerhöhung des Impulszuges I2 führt. Auch ohne die Verbindung zwischen Q7 und R führt ein Inhalt des Zählers CO zwischen 64 und 112 zu L-Signal, das am Ende der Zykluszeit ins D-Flip-Flop F übernommen werden und zum gewünschten Erlöschen der Leuchtdiode LED führen würde. Liegt der Inhalt des Zählers CO jedoch zwischen 112 und 128, oder allgemeiner zwischen $n \cdot 64-16$ und $n \cdot 64$, so erschiene trotz Überschreitung der oberen Grenze des Toleranzbereichs wiederum H-Signal an D-Eingang, so dass die Übernahme dieses Wertes ins D-Flip-Flop nicht zum Erlöschen der Leuchtdiode LED und damit nicht zur Störungsanzeige führen würde. Die Verbindung von Q7 mit R sorgt nun dafür, dass jede Überschreitung des Wertes 63 als Inhalt des Zählers CO als Störung signalisiert wird.

Wie bereits eingangs erwähnt wurde, führen wegen der Breite des Toleranzbandes unsymmetrische Belastungen des Netzes – ohne gleichzeitigen Fehler im Drehstrom-Elektrizitätszähler – erst dann zu einer Fehlanzeige, wenn die Unsymmetrie in der Phase R + 25,7% und − 17,2%, in den Phasen ST dagegen sogar ±42,9% übersteigt. Damit kann der erfindungsgemäss selbstüberwachend ausgebildete Drehstrom-Elektrizitätszähler nicht nur bei symmetrisch belasteten Drehstromnetzen, sondern auch bei Drehstromnetzen mit nicht extremer Unsymmetrie eingesetzt werden.

**Patentansprüche**

1. Elektronischer Drehstrom-Elektrizitätszähler, bei dem für jede Phase ein Multiplizierglied (MR, MS, MT) vorgesehen ist, dem eingangsseitig die der Phase zugehörigen strom- und spannungsproportionalen Signale zugeführt sind und dessen leistungsproportionales Ausgangssignal ($\overline{U}_R$, $\overline{U}_S$, $\overline{U}_T$) zusammen mit den Ausgangssignalen der anderen Multiplizierglieder zu einem Summensignal addiert wird, das in einem Quantisierer (Q) in einen Impulszug (I1) mit leistungsproportionaler Frequenz umgesetzt wird, der in einer Zähleinrichtung (Z) für die zu erfassende Energie zeitlich integriert und angezeigt wird, dadurch gekennzeichnet, dass für eine (R) der drei Phasen (R, S, T) eine zusätzliche Leistungserfassungseinrichtung, zumindestens bestehend aus einem Multiplizierglied (MR1, MP) und einem Prüfquantisierer (Q1), vorgesehen ist, die ausgangsseitig einen Impulszug (I2) mit leistungsproportionaler Frequenz liefert und dass eine Vergleichseinrichtung (V) für die beiden vom Quantisierer (Q) und der Leistungserfassungseinrichtung gelieferten Impulszüge (I1, I2) vorgesehen ist, die einen Signalwechsel einer Anzeigeeinheit (L) auslöst, wenn das Verhältnis der Frequenzen der beiden Impulszüge (I1, I2) die Grenzen eines bestimmten Toleranzbandes überschreitet, wobei diese Grenzen so gewählt sind, dass der Ausfall eines wesentlichen Bauelements zur Überschreitung einer Grenze führt und dass für die zusätzliche Leistungserfassungseinrichtung vorhandene Funktionselemente (WIR, WUR, MR; WIR, WUR, TR, INR) des Drehstrom-Elektrizitätszählers (DZ) mitbenutzt werden (Fig. 1, Fig. 2).

2. Drehstrom-Elektrizitätszähler nach Anspruch 1, dadurch gekennzeichnet, dass der zusätzlichen Leistungserfassungseinrichtung (MP, Q1) die eingangsseitigen Signale oder interne Signale ($\overline{U}_{IR}$), $U_{IR}$, $U_{TR}$) eines einer Phase zugeordneten Multipliziergliedes (MR) zugeführt sind (Fig. 2).

3. Drehstrom-Elektrizitätszähler nach Anspruch 1, dadurch gekennzeichnet, dass zumindest eines (MR) der den drei Phasen (R, S, T) zugeordneten Multiplizierglieder (MR, NS, MT) ausgangsseitig ein Spannungssignal ($\overline{U}_R$) liefert und dass zur Bildung der zusätzlichen Leistungserfassungseinrichtung das ausgangsseitige Spannungssignal ($\overline{U}_R$) dieses Multipliziergliedes (MR) dem Prüfquantisierer (Q1) der zusätzlichen Leistungserfassungseinrichtung zugeführt ist (Fig. 1).

4. Drehstrom-Elektrizitätszähler nach Anspruch 1, bei dem die den einzelnen Phasen zugeordneten Multiplizierglieder als jeweils einen Impulsdauer-Impulspausen-Modulator und einen von diesem gesteuerten Schalter aufweisende Time-Division-Multiplizierer ausgeführt sind, dadurch gekennzeichnet, dass auch als Multiplizierglied (MP) der zusätzlichen Leistungserfassungseinrichtung (MP, Q1) ein Time-Division-Multiplizierer dient (Fig. 2).

5. Drehstrom-Elektrizitätszähler nach einem der Ansprüche 1 bis 4, bei dem ein nach dem Kondensator-Umladeverfahren oder dem Ladungskompensationsverfahren arbeitender Quantisierer zur Verarbeitung des Summensignals dient, dadurch gekennzeichnet, dass auch der Prüfquantisierer (Q1) als nach dem Kondensator-Umladeverfahren oder Ladungskompensationsverfahren arbeitend erstellt ist.

6. Drehstrom-Elektrizitätszähler nach Anspruch 4, dadurch gekennzeichnet, dass der Schalter (12) des Time-Division-Multiplizierers (MP) der zusätzlichen Leistungserfassungseinrichtung (MP, Q1) von dem Impulsdauer-Impulspausen-Modulator (TR) des derjenigen Phase (R) zugehörigen Time-Division-Multiplizierers (MR) angesteuert wird, von der auch das zweite zu multiplizierende Signal ($_{IR}$) abgeleitet ist (Fig. 2).

7. Drehstrom-Elektrizitätszähler nach Anspruch 6, dadurch gekennzeichnet, dass die Ansteuerung des Schalters (12) über ein Exclusiv-ODER-Gatter (EM1) erfolgt, dessen zweiter Eingang mit dem Ausgang des Prüfquantisierers (Q1) verbunden ist und dass das der entsprechenden Phase (R) zugehörige stromproportionale Signal ($U_{IR}$) als Spannungssignal einmal invertiert (INR) über einen ersten Widerstand (13) und einmal nichtinvertiert über einen zweiten Widerstand (14) und den Schalter (12) dem Eingang des Prüfquantisierers (Q1) zugeführt ist, wobei der erste Widerstand (13) den doppelten Widerstandswert des zweiten (12) aufweist (Fig. 2).

8. Drehstrom-Elektrizitätszähler für beide Energieflussrichtungen mit einem Energierichtungsdiskriminator nach Anspruch 7, dadurch gekennzeichnet, dass das bistabile Ausgangssignal des Energierichtungsdiskriminators (D) dem einen Eingang eines weiteren Exclusiv-ODER-Gatters (EM2) zugeführt ist, dass das Ausgangssignal des Prüfquantisierers (Q1) am zweiten Eingang des weiteren Exclusiv-ODER-Gatters (EM2) ansteht und dass der Ausgang des weiteren Exclusiv-ODER-Gatters (EM2) mit dem zweiten Eingang des Exclusiv-ODER-Gatters (EM1) verbunden ist.

9. Drehstrom-Elektrizitätszähler nach einem der Ansprüche 1 bis 8, dadurch gekennzeichnet, dass die Vergleichseinrichtung (V) für die beiden, vom Quantisierer (Q) und dem Prüfquantisierer (Q1) der zusätzlichen Leistungserfassungseinrichtung (MP, Q1) gelieferten Impulszüge (I1, I2) einen zurückstellbaren Zähler (CO) aufweist, dessen Zähleingang (Z) der eine Impulszug (I2) zugeführt ist, wobei die Zahl der eingehenden Impulse für jeweils eine durch Frequenzteilung (FT) aus dem anderen Impulszug (I1) abgeleiteten Zykluszeit erfasst und am Ende der Zykluszeit jeweils vor Rückstellung des Zählers (CO) daraufhin überprüft wird, ob sie ausserhalb des bei einer einwandfreien Funktion aller den drei Phasen (R, S, T) zugeordneten Funktionsgruppen des Drehstrom-Elektrizitätszählers (DC) gegebenen Toleranzbandes liegt.

10. Drehstrom-Elektrizitätszähler nach Anspruch 9, dadurch gekennzeichnet, dass als rückstellbarer Zähler (CO) ein Binärzähler dient.

11. Drehstrom-Elektrizitätszähler nach Anspruch 9 oder 10, dadurch gekennzeichnet, dass zur Bildung der Zykluszeit dem Quantisierer (Q) ein Frequenzteiler (FT) nachgeschaltet ist, dessen Ausgangsimpulse auch die Zähleinrichtung (Z, Z') für die zu erfassende elektrische Energie speisen.

12. Drehstrom-Elektrizitätszähler nach den Ansprüchen 10 oder 11, dadurch gekennzeichnet, dass die das Toleranzband bestimmenden Zahlenwerte (48, 64) durch ein oder gegebenenfalls mehrere durch eine logische Verknüpfungsschaltung (D1, D2) verknüpfte Ausgangssignale (Q5, Q6) des Binärzählers (CO) dargestellt sind (Fig. 3).

13. Drehstrom-Elektrizitätszähler nach Anspruch 12, dadurch gekennzeichnet, dass das Ausgangssignal des Binärzählers (CO), bzw. der logischen Verknüpfungsschaltung (D1, D2) an den D-Eingang (D) eines D-Flip-Flops (F) geführt ist und dass das die Zykluszeit bestimmende Ausgangssignal des Frequenzteilers (FT) am Takteingang (C) des D-Flip-Flops (F) und über ein Verzögerungs- (16) und ein Differenzierglied (17) am Rücksetzeingang (R) des Binärzählers (CO) ansteht (Fig. 3).

14. Drehstrom-Elektrizitätszähler nach Anspruch 13, dadurch gekennzeichnet, dass die Anzeigeeinheit (L) vom Ausgangssignal ($\overline{Q}$) des D-Flip-Flops (F) gesteuert ist.

15. Drehstrom-Elektrizitätszähler nach Anspruch 13, dadurch gekennzeichnet, dass das Ausgangssignal (Q7) des Binärzählers (CO), das um eine Wertigkeit höher ist als das höchstwertige an den D-Eingang (D) des D-Flip-Flops (F) geführte Signal (Q6) des Binärzählers (CO), an den Rücksetzeingang (R) des D-Flip-Flops (F) geführt ist.

## Claims

1. An electronic three-phase electricity meter, wherein a multiplier unit (MR, MS, MT) is provided for each phase, supplied at its input end with signals proportional to the current and voltage associated with the phase, and emits a power-proportional output signal ($\overline{U}_R$, $\overline{U}_S$, $\overline{U}_T$) that is added to the output signals of the other multiplier units to form a sum signal which is converted in a quantizer (Q) into a pulse train (I1) having a power-proportional frequency and then integrated with respect to time in a counting device (Z) for the energy to be detected, and the result displayed, characterised in that for one (R) of the three phases (R, S, T) an additional power detection device is provided, consisting at least of one multiplier unit (MR1, MP) and a test quantizer (Q1), which device supplies at its output end a pulse train (I2) having a power-proportional frequency, and that a comparator device (E) is provided for the two pulse trains (I1, I2) supplied by the quantizer (Q) and the power detection device, which comparison device triggers a signal change in a display unit (L) when the ratio of the frequencies of the two pulse trains (I1, I2) exceeds the limits of a specified tolerance band, these limits being selected such that the breakdown of an essential component leads to the exceeding of a limit, existing function elements (WIR, WUR, MR; WIR, WUR, TR, INR) of the three-phase electricity meter (DZ) also being used for the additional power detection device. (Fig. 1, Fig. 2).

2. A three-phase electricity meter as claimed in Claim 1, characterised in that the additional power detection device (MP, Q1) is supplied with the input-end signals or internal signals ($\overline{U}_{IR}$, $U_{IR}$, $U_{TR}$) of a multiplier unit (MR) assigned to one phase. (Fig. 2).

3. A three-phase electricity meter as claimed in Claim 1, characterised in that at least one (MR) of the multiplier units (MR, NS, MT) assigned to the three phases (R, S, T) supplies an output signal ($\overline{U}_R$) at its output, and that the additional power detection device is formed in that the voltage output signal ($\overline{U}_R$) of this multiplier unit (MR) is supplied to the test quantizer (Q1) of the additional power detection device. (Fig. 1).

4. A three-phase electricity meter as claimed in Claim 1, wherein the multiplier units assigned to the individual phases are designed as time division multiplexers which each comprise a pulse-duration/pulse-pause modulator and a switch controlled by the latter, characterised in that a time division multiplexer also serves as multiplier unit (MP) of the additional power detection device (MP, Q1). (Fig. 2).

5. A three-phase electricity meter as claimed in one of Claims 1 to 4, wherein a quantizer which operates in accordance with the capacitor-recharging process or the charge compensation process, serves to process the sum signal, characterised in that the test quantizer (Q1) is also set up to operate in accordance with the capacitor-recharging process or charge compensation process.

6. A three-phase electricity meter as claimed in Claim 4, characterised in that the switch (12) of the time division multiplexer (MP) of the additional power detection device (MP, Q1) is driven by the pulse-duration/pulse-pause modulator (TR) of the time division multiplexer (MR) assigned to that phase (R) from which the second signal (IR) to be multiplied is also derived. (Fig. 2).

7. A three-phase electricity meter as claimed in Claim 6, characterised in that the switch (12) is driven via an exclusive-OR gate (EM1) whose second input is connected to the output of the test quantizer (Q1), and that the current-proportional signal ($U_{IR}$) associated with the corresponding phase (R) is fed as voltage signal, on the one hand via a first resistor (13), in inverted form (INR), and on the other hand via a second resistor (14) and the switch (12), in non-inverted form, to the input of the test quantizer (Q1), the resistance value of the first resistor (13) being double that of the second resistor (12). (Fig. 2).

8. A three-phase electricity meter for both energy flow directions, with an energy direction discriminator as claimed in Claim 7, characterised in that the bistable output signal of the energy direction discriminator (D) leads to the first input of a further exclusive-OR gate (EM2), that the output signal of the test quantizer (Q1) occurs at the second input of the further exclusive-OR gate (EM2), and that the output of the further exclusive-OR gate (EM2) is connected to the second input of the exclusive-OR gate (EM1).

9. A three-phase electricity meter as claimed in one of Claims 1 to 8, characterised in that for both of the pulse trains (I1, I2) which are supplied by the quantizer (Q) and the test quantizer (Q1) of the additional power detection device (MP, Q1), the comparison device (E) has a resettable counter (CO) whose counting input (Z) is supplied with the first pulse train (I2), where the number of incoming pulses is detected for a cycle time derived from the other pulse train (I1) by frequency division (ST), and at the end of the cycle time, prior to the resetting of the counter (CO), it is checked to establish whether this number lies outside the tolerance band based on a satisfactory function of all the function groups of the three-phase electricity meter (DC) assigned to the three phases (R, S, T).

10. A three-phase electricity meter as claimed in Claim 9, characterised in that a binary counter serves as resettable counter (CO).

11. A three-phase electricity meter as claimed in Claim 9 or 10, characterised in that for the formation of the cycle time, the quantizer (Q) is connected at its output to a frequency divider (FT) whose output pulses also feed the counting device (Z, Z') for the electrical energy which is to be detected.

12. A three-phase electricity meter as claimed in Claim 10 or 11, characterised in that the numerical values (48, 64) which determine the tolerance band are represented by one or possibly more than one output signal (Q5, Q6) of the binary counter (CO), which are logic-linked by a logic-linking circuit (D1, D2). (Fig. 3).

13. A three-phase electricity meter as claimed in Claim 12, characterised in that the output signal of the binary counter (CO) and of the logic-linking circuit (D1, D2) leads to the D-input (D) of a D-type flip-flop (F), and that the output signal of the frequency divider (FT) which determines the cycle time occurs at the clock input (C) of the D-type flip-flop (F), and – via a delay element (16) and a differentiator element (17) – at the reset input (R) of the binary counter (CO). (Fig. 3).

14. A three-phase electricity meter as claimed in Claim 13, characterised in that the display unit (L) is controlled by the output signal ($\overline{Q}$) of the D-type flip-flop (F).

15. A three-phase electricity meter as claimed in Claim 13, characterised in that the output signal (Q7) of the binary counter (CO), which is one order of magnitude higher than the highest-value signal (Q6) of the binary counter (CO) fed to the D-input (D) of the D-type flip-flop (F), is fed to the reset input (R) of the D-type flip-flop (F).

## Revendications

1. Compteur d'électricité électronique à courant triphasé, dans lequel il est prévu pour chaque phase un circuit multiplicateur (MR, MS, MT), auquel sont envoyés, du côté entrée, les signaux associés à la phase et proportionnels au courant et à la tension et dont le signal de sortie ($\overline{U}_R$, $\overline{U}_S$, $\overline{U}_T$), proportionnel à la puissance et les signaux de sortie des autres circuits multiplicateurs sont additionnés pour fournir un signal somme qui est transformé, dans un circuit de quantification (Q), en un train d'impulsions (I1) possédant une fréquence proportionnelle à la puissance et qui est intégré dans le temps et affiché dans un dispositif (Z) de comptage de l'énergie devant être détectée, caractérisé par le fait que pour l'une (R) des trois phases (R, S, T), il est prévu un dispositif supplémentaire de détection de puissance, constitué au moins par un circuit multiplicateur (MR1, MP) et par un dispositif de quantification de contrôle (Q1), et qui délivre, du côté sortie, un train d'impulsions (Q2) possédant une fréquence proportionnelle à la puissance et qu'il est prévu un circuit comparateur (V) pour les deux trains d'impulsions (I1, I2) délivrés par le dispositif de quantification (Q) et par le dispositif de détection de puissance et qui déclenche un changement de signal d'une unité d'affichage (L), lorsque le rapport des fréquences des deux trains d'impulsions (I1, I2) dépasse les limites d'une bande de tolérance déterminée, ces limites étant choisies de telle sorte que la défaillance d'un composant essentiel aboutit à un dépassement d'une limite et que des éléments fonctionnels existant (WIR, WUR, MR; WIR, WUR, TR, INR) du compteur d'électricité à courant triphasé (DZ) sont utilisés conjointement pour le dispositif supplémentaire de détection de puissance (figure 1, figure 2).

2. Compteur d'électricité à courant triphasé suivant la revendication 1, caractérisé par le fait que les signaux situés du côté entrée ou des signaux internes ($\overline{U}_{IR}$, $U_{IR}$, $U_{TR}$) d'un circuit multiplicateur (MR), associé à une phase, sont envoyés au dispositif supplémentaire (MP, Q1) de détection de puissance (figure 2).

3. Compteur d'électricité à courant triphasé suivant la revendication 1, caractérisé par le fait qu'au moins l'un (MR) des circuits multiplicateurs (MR, NS, MT), associés aux trois phases (R, S, T), délivre un signal de tension ($\overline{U}_R$) du côté sortie et que pour la formation du dispositif supplémentaire de détection de puissance, le signal de tension ($\overline{U}_R$) situé du côté sortie de ce multiplicateur (MR) est envoyé au dispositif de quantification de contrôle (Q1) du dispositif supplémentaire de détection de puissance (figure 1).

4. Compteur d'électricité à courant triphasé suivant la revendication 1, dans lequel les circuits multiplicateurs associés aux différentes phases sont réalisés sous la forme respectivement d'un modulateur de durées d'impulsions et de pauses entre impulsions, et par un multiplicateur à division du temps comportant des commutateurs commandés par ce modulateur, caractérisé par le fait qu'un multiplicateur à division du temps est également utilisé en tant que circuit multiplicateur (MT) du dispositif supplémentaire de détection de puissance (MP, Q1) (figure 2).

5. Compteur d'électricité à courant triphasé suivant l'une des revendications 1 à 4, dans lequel un dispositif de quantification travaillant selon le procédé d'inversion de charge d'un condensateur ou selon le procédé de compensation de charge, est utilisé pour le traitement du signal somme, caractérisé par le fait que le dispositif de quantification de contrôle (Q1) est également réalisé de manière à travailler selon le procédé d'inversion de charge d'un condensateur ou selon le procédé de compensation de charge.

6. Compteur d'électricité à courant triphasé suivant la revendication 4, caractérisé par le fait que le commutateur (12) du multiplicateur à division du temps (MP) du dispositif supplémentaire de détection de puissance (MP, Q1) est commandé par le modulateur (TR) de durées d'impulsions et de pauses entre impulsions du multiplicateur à division du temps (MR) associé à la phase (R) dont est dérivé également le second signal ($U_{IR}$) devant faire l'objet d'une multiplication.

7. Compteur d'électricité à courant triphasé suivant la revendication 6, caractérisé par le fait que la commande du commutateur (12) est réalisée par l'intermédiaire d'un circuit OU-Exclusif (EM1), dont la seconde entrée est reliée à la sortie du dispositif de quantification de contrôle (Q1) et que le signal ($U_{IR}$) proportionnel au courant et associé à la phase correspondante (R) est envoyé en tant que signal de tension, une fois en étant inversé (INR) par l'intermédiaire d'une première résistance (13) et une fois en n'étant pas inversé par l'intermédiaire d'une seconde résistance (14) du commutateur (12), à l'entrée du dispositif de quantification de contrôle (Q1), la première résistance (13) possédant une valeur résistive double de celle de la seconde résistance (12) (figure 2).

8. Compteur d'électricité à courant triphasé pour les deux sens de circulation de l'énergie, comportant un discriminateur du sens de circulation de l'énergie, suivant la revendication 7, caractérisé par le fait que le signal de sortie bistable du discriminateur (D) du sens de circulation de l'énergie est envoyé à une entrée d'une autre porte OU-Exclusif (EMD), que le signal de sortie du dispositif de quantification de contrôle (Q1) est présent sur la seconde entrée de l'autre porte OU-Exclusif (EM2) et que la sortie de l'autre porte OU-Exclusif (EM2) est reliée à la seconde entrée de la porte OU-Exclusif (EM2).

9. Compteur d'électricité suivant l'une des revendications 1 à 8, caractérisé par le fait que le dispositif comparateur (V) pour les deux trains d'impulsions (I1, I2), délivrées par le dispositif de quantification (Q) et par le dispositif de quantification de contrôle (Q1) du dispositif supplémentaire de détection de puissance (MP, Q1), comporte un compteur (CO) pouvant être amené à zéro, à l'entrée (Z) de comptage duquel est envoyé un train d'impulsions (I2), auquel cas le nombre des impulsions d'arrivée est déterminé pour la durée d'un cycle obtenue à partir de l'autre train d'impulsions (I1) par division de fréquence (FT), et est contrôlé à la fin de la durée du cycle, respectivement avant la remise à zéro du compteur (CO), pour savoir s'il se situe en-dehors de la bande de tolérance déterminée pour un fonctionnement parfait de tous les groupes fonctionnels, associés aux trois phases (R, S, T), du compteur d'électricité à courant triphasé (DC).

10. Compteur d'électricité à courant triphasé suivant la revendication 9, caractérisé par le fait qu'on utilise un compteur binaire en tant que compteur (CO) pouvant être remis à zéro.

11. Compteur d'électricité à courant triphasé suivant la revendication 9 ou 10, caractérisé par le fait que pour la formation de la durée du cycle, en aval du dispositif de quantification (Q) se trouve branché un diviseur de fréquence (FT) dont les impulsions de sortie alimentent également le dispositif de comptage (Z, Z') pour l'énergie électrique devant être détectée.

12. Compteur d'électricité à courant triphasé suivant les revendications 10 ou 11, caractérisé par le fait que les valeurs chiffrées (48, 64), qui déterminent la bande de tolérance, sont représentées par un ou éventuellement plusieurs signaux de sortie (Q5, Q6) du compteur binaire (CO), combinés au moyen d'un circuit de combinaison logique (D1, D2) (figure 3).

13. Compteur d'électricité à courant triphasé suivant la revendication 12, caractérisé par le fait que le signal de sortie du compteur binaire (CO) ou du circuit de combinaison logique (D1, D2) est envoyé à l'entrée (D) d'une bascule bistable du type D (F), et que le signal de sortie du diviseur de fréquence (FT), qui détermine la durée du cycle, est présente à l'entrée de cadence (C) de la bascule bistable de type D (F) et, par l'intermédiaire d'une ligne à retard (16) et d'un circuit différentiateur (17), sur l'entrée de remise à zéro (T) du compteur binaire (CO) (figure 3).

14. Compteur d'électricité à courant triphasé suivant la revendication 13, caractérisé par le fait que l'unité d'affichage (L) est commandée par le signal de sortie ($\bar{Q}$) de la bascule bistable de type D (F).

15. Compteur d'électricité à courant triphasé suivant la revendication 13, caractérisé par le fait que le signal de sortie (Q7) du compteur binaire (CO), qui est supérieur d'un poids au signal de poids maximum (Q6) du compteur binaire (CO), envoyé à l'entrée D (D) de la bascule bistable du type D (F), est envoyé à l'entrée de remise à l'état initial (R) de la bascule bistable du type D (F).

FIG 1

FIG 2

0 052 255

FIG 3

FIG 4